(19) Europäisches Patentamt
European Patent Office
Office européen des brevets

(11) Veröffentlichungsnummer : **0 067 464 B1**

(12) **EUROPÄISCHE PATENTSCHRIFT**

(45) Veröffentlichungstag der Patentschrift :
13.03.85

(51) Int. Cl.⁴ : **H 03 K 23/50**

(21) Anmeldenummer : 82200601.1

(22) Anmeldetag : 17.05.82

(54) Dynamischer Synchron-Binärzähler mit identischem Aufbau der Stufen.

(30) Priorität : 12.06.81 EP 81200648
30.03.82 DE 3211664

(43) Veröffentlichungstag der Anmeldung :
22.12.82 Patentblatt 82/51

(45) Bekanntmachung des Hinweises auf die Patenterteilung : 13.03.85 Patentblatt 85/11

(84) Benannte Vertragsstaaten :
DE FR GB IT NL

(56) Entgegenhaltungen :
DE-A- 2 603 704
DE-A- 2 743 450
DE-A- 2 846 957
US-A- 3 657 557
US-A- 4 114 052
Patent Abstracts of Japan Band 4, Nr. 133, 18. September 1980 Seite 88E26

(73) Patentinhaber : Deutsche ITT Industries GmbH
Hans-Bunte-Strasse 19 Postfach 840
D-7800 Freiburg (DE)
DE
ITT INDUSTRIES INC.
320 Park Avenue
New York, NY 10022 (US)

(72) Erfinder : Backes, Reiner, Dipl.-Ing.
Am Märzengraben 2
D-7800 Freiburg-Tiengen (DE)
Erfinder : Schmidtpott, Friedrich, Ing.grad.
Gewerbestrasse 13
D-7803 Gundelfingen (DE)
Erfinder : Neal, Mathew, Dipl.-Ing.
Innsbrucker Strasse 50
D-7800 Freiburg i.br. (DE)

(74) Vertreter : Stutzer, Gerhard, Dr.
Deutsche ITT Industries GmbH Patent- und Lizenzabteilung Hans-Bunte-Strasse 19 Postfach 840
D-7800 Freiburg (DE)

**Beschreibung**

Die Erfindung betrifft dynamische Synchron-Binärzähler mit identischem Aufbau der Stufen, die mit Isolierschicht-Feldeffekttransistoren in mit zwei Taktsignalen betriebener Verhältnis-Schaltungstechnik realisiert sind, vgl. die Oberbegriffe der beiden Nebenansprüche 1 und 2. Die darin jeweils enthaltenen Merkmale sind aus der Offenlegungsschrift DE 28 46 957 A1, Fig. 2 bekannt. Ohne daß sich darin ein näherer Hinweis befindet, kann angenommen werden, daß es sich bei den dort verwendeten beiden Taktsignalen um die bekannten sich nicht überlappenden Taktsignale der Zweiphasen-Verhältnis-Schaltungstechnik von mit Isolierschicht-Feldeffekttransistoren aufgebauten integrierten Schaltungen handelt ; vgl. zu dieser Technik beispielsweise die Zeitschrift « The Electronic Engineer », März 1970, Seiten 56 bis 61.

Bei der bekannten Anordnung nach der genannten Offenlegungsschrift werden nur in der niederstwertigen Stufe die beiden Taktsignale benutzt, während als erstes Taktsignal in den jeweils nachfolgenden Stufen das Ausgangssignal des Übertrag-Transfertransistors dient. Gegen hohe Stufenzahlen sinkt somit die Frequenz des die jeweilige Stufe steuernden zweiten Taktsignals entsprechend der zugehörigen Zweierpotenz ab, aus welcher Tatsache sich eine Begrenzung der insgesamt möglichen Stufenzahl ergibt. Für dynamischen Betrieb ist nämlich bekanntlich eine Mindestfrequenz der Taktsignale erforderlich. Nach Überlegungen des Erfinders dürften beim gegenwärtigen Stand der Technik mit der bekannten Anordnung lediglich etwa achtstufige Synchron-Binärzähler realisierbar sein.

Hier will nun die in den Ansprüchen gekennzeichnete Erfindung Abhilfe schaffen, deren Aufgabe es ist, dynamische Synchron-Binärzähler mit identischem Aufbau der Stufen entsprechend den Oberbegriffen der Ansprüche 1 und 2 anzugeben, die insbesondere keine Begrenzung hinsichtlich der möglichen Stufenzahl aufweisen.

Die Erfindung wird nun anhand der Figuren der Zeichnung näher erläutert ;

Figur 1 zeigt teilweise schematisch das Schaltbild einer Ausführungsform der ersten Lösungsvariante,

Figur 2 zeigt die Kurvenform der für die Anordnung nach Fig. 1 erforderlichen beiden Taktsignale,

Figur 3 zeigt teilweise schematisch das Schaltbild einer Ausführungsform der zweiten Lösungsvariante,

Figur 4 zeigt eine Weiterbildung der Anordnung nach Fig. 3 für Vorwärts-Rückwärts-Zähler,

Figur 5 zeigt die Kurvenverläufe der bei den Anordnungen nach den Fig. 3 und 4 erforderlichen beiden Taktsignale, und

Figur 6 zeigt eine Weiterbildung der Anordnung nach Fig. 4 als Vorwärts/Rückwärtszähler.

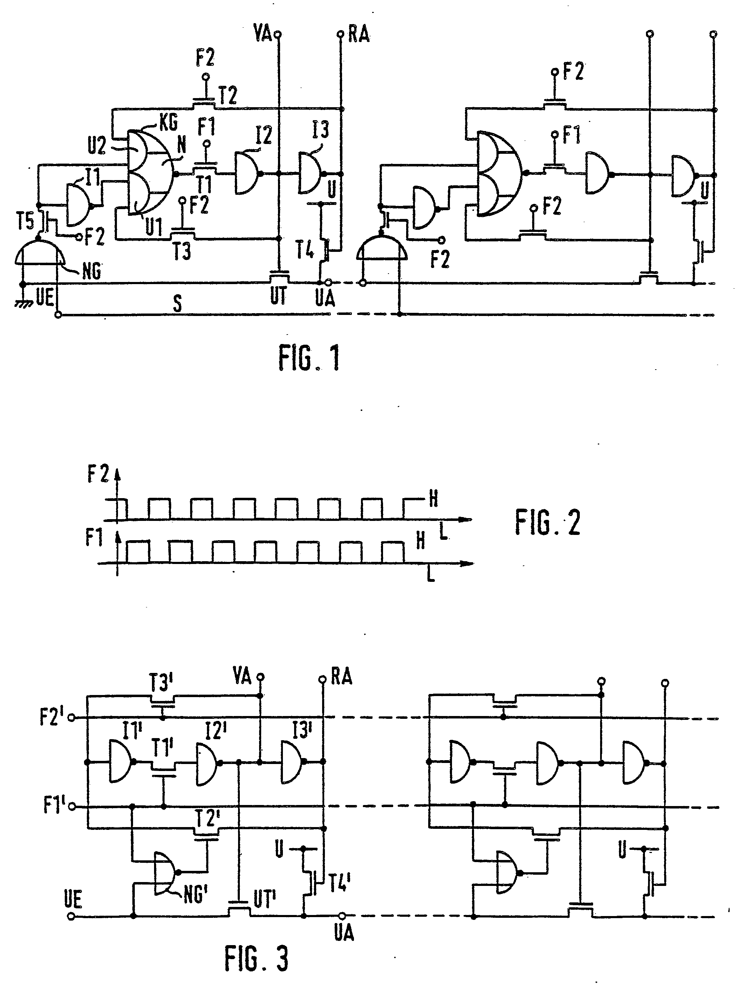

Die Fig. 1 zeigt als Ausführungsbeispiel der ersten Lösungsvariante der Erfindung teilweise schematisch das Schaltbild zweier Stufen, deren Hintereinanderschaltung durch die entsprechenden gestrichelten Linien angedeutet ist. Die vollständig mit Bezugszeichen versehene, linke Stufe ist die niederstwertige Stufe, die sich schaltungsmäßig von den übrigen Stufen voraussetzungsgemäß nicht unterscheidet, jedoch lediglich bezüglich ihrer Außenbeschaltung das Sondermerkmal aufweist, daß ihr Übertrag-Eingang UE mit dem Schaltungsnullpunkt verbunden ist, während der Übertrag-Eingang der anderen Stufen mit dem Übertrag-Ausgang der jeweils vorausgehenden Stufe verbunden ist.

Die einzelne Stufe besteht in Fig. 1 aus dem NOR-Gatter NG, dem Komplexgatter KG, das die beiden UND-Verknüpfungen U1, U2 enthält, deren Ausgangssignale über die NOR-Verknüpfung N weiterverarbeitet werden, die drei Inverter I1, I2, I3, die fünf Transfertransistoren T1, T2, T3, T4, T5 und den Übertrag-Transfertransistor UT.

Der erste Eingang des NOR-Gatters NG liegt am Übertrag-Eingang UE und der zweite Eingang an der Stoppleitung S, über die bei Anlegen des positiveren Pegels H zweier Binärsignalpegel der Synchron-Binärzähler angehalten werden kann. Der Ausgang des NOR-Gatters NG ist über den vom zweiten Taktsignal F2 gesteuerten Strompfad des fünften Transfertransistors T5 mit dem Eingang des ersten Inverters I1 und mit dem zweiten Eingang der UND-Verknüpfung U2 des Komplexgatters KG verbunden.

Es ist darauf hinzuweisen, daß für die Zwecke der Beschreibung der vorliegenden Erfindung bewußt ein Unterschied gemacht ist zwischen den Bezeichnungen « ...-Gatter » und « ...-Verknüpfung ». Unter « Gatter » sind solche logischen Isolierschicht-Feldeffekttransistor-Grundschaltungen zu verstehen, die einen eigenen Arbeitswiderstand aufweisen, was im Schaltsymbol dadurch zum Ausdruck kommt, daß die Ausgangsleitung am Berührungspunkt mit dem Halbkreis des Verknüpfungssymbols den zur Darstellung einer Invertierung üblichen Punkt aufweist. « Verknüpfungen » sind demgegenüber nur Teile von « Gattern » und haben insbesondere keinen derartigen eigenen Arbeitswiderstand.

Der Ausgang des ersten Inverters I1 liegt am zweiten Eingang der ersten UND-Verknüpfung U1 des Komplexgatters KG, während deren erster Eingang über den vom zweiten Taktsignal F2 gesteuerten Strompfad des dritten Transfertransistors T3 mit dem Vorwärtszähl-Ausgang VA verbunden ist. In ähnlicher Weise liegt der erste Eingang der zweiten UND-Verknüpfung U2 über den vom zweiten Taktsignal gesteuersten Strompfad des zweiten Transfertransistors T2 am Rückwärtszähl-Ausgang RA.

Der Ausgang des Komplexgatters KG liegt über den vom ersten Taktsignal F1 gesteuerten Strompfad des ersten Transfertransistors T1 am Eingang des zweiten Inverters I2, dessen Aus-

gang am Eingang des dritten Inverters I3 liegt und den Vorwärtszähl-Ausgang VA bildet sowie mit dem Gate des zwischen dem Übertrag-Eingang UE und dem Übertrag-Ausgang UA mit seinem gesteuerten Strompfad liegenden Übertrag-Transistors UT verbunden ist. Der Ausgang des dritten Inverters I3 bildet den Rückwärtszähl-Ausgang RA, der am Gate des über seinen gesteuerten Strompfad den Übertrag-Ausgang UA mit der konstanten Spannung U verbindenden vierten Transfertransistors T4 angeschlossen ist.

Entsprechend Fig. 1 aufgebaute Zähler haben die Eigenschaft, daß bei Verwendung als Vorwärtszähler die Vorwärtszähl-Ausgänge VA, dagegen bei Verwendung als Rückwärtszähler die Rückwärtszähl-Ausgänge RA zu benutzen sind. Die beiden Taktsignale F1, F2 sind dabei nach der bekannten Zweiphasen-Verhältnis-Schaltungstechnik nichtüberlappende Taktsignale, wie sie schematisch in Fig. 2 dargestellt sind.

Mit der Stoppleitung S kann der Zählvorgang, wie bereits erwähnt, angehalten werden, und zwar dann, wenn bei der für das Ausführungsbeispiel nach Fig. 1 vorausgesetzten positiven Logik und der ferner vorausgesetzten Realisierung in N-Kanal-Anreicherungstyp-Technik an sie ein H-Pegel angelegt wird. In diesem Fall werden durch H-Pegel angesteuerte Transistoren leitend gesteuert.

Die Vorteile der ersten Lösungsvariante bestehen unter anderem darin, daß hohe Taktfrequenzen zugelassen werden können und daß alle Stufen mit diesen hochfrequenten Taktsignalen betrieben werden. Ferner liegen alle auftretenden H-Pegel nur maximal um die Schwellspannung eines Transistors unter der konstanten Spannung U.

In Fig. 3 ist das Schaltbild einer Ausführungsform der zweiten Lösungsvariante nach der Erfindung gezeigt. Es sind wiederum zwei in Reihe liegende Stufen eines entsprechenden Synchron-Binärzählers gezeigt, wobei die links gezeigte Stufe mit den eingetragenen Bezugszeichen die niederstwertige Stufe ist. In ihr liegt der Übertrag-Eingang UE entweder am Schaltungsnullpunkt, in welchem Fall Zählbetrieb vorliegt, oder an der konstanten Spannung U, wodurch der Zählbetrieb unterbrochen bzw. gestoppt wird. Diese Umschaltung kann selbstverständlich auch mit den üblichen elektronischen Mitteln erzielt werden.

Die Schaltung einer Stufe nach der zweiten Lösungsvariante entsprechend der Fig. 3 unterscheidet sich von der Schaltung einer Stufe nach Fig. 1 im wesentlichen dadurch, daß das dortige Komplexgatter KG entfällt und somit der erste Inverter I1' nach Fig. 3 über den vom ersten Taktsignal F1' gesteuerten Transfertransistor T1' mit dem Eingang des zweiten Inverters I2' verbunden ist. Ferner liegt der zweite Eingang des NOR-Gatters NG' nicht an der Stoppleitung S nach Fig. 1, die bei der zweiten Lösungsvariante nach Fig. 3 nicht vorhanden ist, sondern wird mit dem ersten Taktsignal F1' angesteuert. Im übrigen entspricht die Schaltung jeder Stufe der Lösungsvariante nach Fig. 3 derjenigen nach Fig. 1, wobei jedoch zur besseren Unterscheidung die einzelnen Schaltungsteile mit den mit einem Strich versehenen Bezugszeichen bezeichnet sind. Es entsprechen sich also Bezugszeichen mit und ohne Strich in den Fig. 1 und 3.

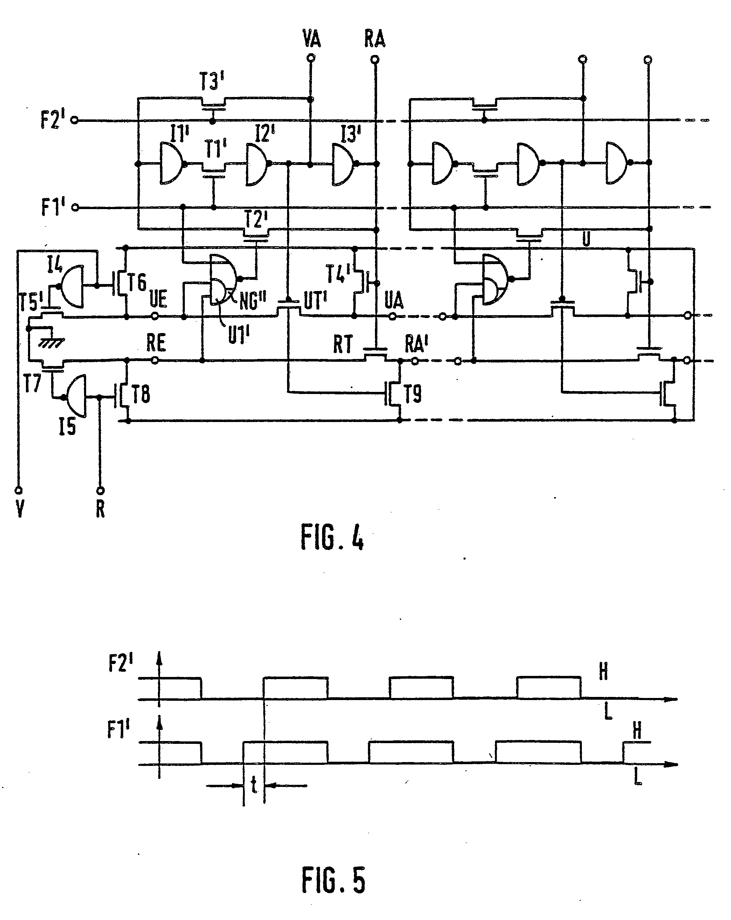

Die Lösungsvariante nach Fig. 3 unterscheidet sich von der nach Fig. 1 ferner wesentlich dadurch, daß sie nicht mit nichtüberlappenden Taktsignale nach Fig. 2 sondern mit solchen nach Fig. 5 zu betreiben ist. Während die nichtüberlappenden Taktsignale nach Fig. 2 aus einem Rechtecksignal durch Invertierung und eine nachfolgende Impulsformerstufe, beispielsweise nach der Offenlegungsschrift DE 26 03 704 A1 erzeugt werden können, sind die beiden Taktsignale F1', F2' Taktsignale mit Überlappung, und zwar derart, daß die beiden H-L-Flanken synchron sind, die L-H-Flanke des zweiten Taktsignals gegenüber der des ersten dagegen mindestens um die Zeit t verzögert ist, die mindestens gleich der Signallaufzeit des zweiten Inverters I2' ist. Diese Inverter-Signallaufzeit t hängt von der flächenmäßigen Dimensionierung dieses Inverters ab, in die insbesondere auch die Eingangskapazitäten der von seinem Ausgang angesteuerten Stufen eingehen. Wie die Fig. 5 zeigt, überlappen sich die beiden Taktsignale F1', F2' derart, daß sie beispielsweise aus einem Rechtecksignal durch zweimalige Invertierung in zwei hintereinandergeschalteten Invertern erzeugt werden können. Dadurch befindet man sich auch bezüglich der Mindest-Verzögerungszeit t im allgemeinen auf der sicheren Seite.

Obwohl auch für die zweite Lösungsvariante nach Fig. 3 die prinzipielle Eigenschaft besteht, bei Benutzung der Vorwärtszähl-Ausgänge VA den Synchron-Binärzähler als Vorwärtszähler benutzen zu können und in entsprechender Weise als Rückwärtszähler bei Benutzung der Rückwärtszähl-Ausgänge RA, kann es in manchen Anwendungsfällen erforderlich sein, eine Umschaltmöglichkeit zwischen Vorwärts- und Rückwärtszählen vorzusehen. Dies kann selbstverständlich für beide Lösungsvarianten dadurch geschehen, daß für sämtliche Vorwärts- bzw. Rückwärtszähl-Ausgänge eine entsprechende Umschaltung vorgesehen wird. Bei großer Stufenzahl solcher Zähler kann dies jedoch einen unvertretbar großen Aufwand bedeuten. Die Fig. 4 zeigt daher eine andere Möglichkeit, wie ein Zähler nach der zweiten Lösungsvariante entsprechend Fig. 3 von Vorwärts- auf Rückwärtszählen umgeschaltet werden kann.

Hierzu ist in das NOR-Gatter NG' nach Fig. 3 die UND-Verknüpfung U1' durch Zuordnung zu dessen erstem Eingang eingefügt. Ferner ist der Zusatz-Übertrag-Transfertransistor RT vorgesehen, dessen vom Rückwärtszähl-Ausgang RA gesteuerter Strompfad zwischen dem Zusatz-Übertrageingang RE und dem Zusatz-Übertragausgang RA angeordnet ist.

Der erste Eingang der UND-Verknüpfung U1' liegt am Übertrag-Eingang UE und deren zweiter Eingang am Zusatz-Übertrag-Eingang RE.

Im Ausführungsbeispiel der Weiterbildung nach Fig. 4 ist der Übertrag-Eingang UE der niederstwertigen Stufe über den gesteuerten Strompfad des fünften Transfertransistors T5' mit dem Schaltungsnullpunkt verbunden und über den vom Vorwärtszähl-Wahlsignal V gesteuerten Strompfad des sechsten Transfertransistors T6 mit der konstanten Spannung U. Dieses Wahlsignal V ist auch dem Eingang des vierten Inverters I4 zugeführt, dessen Ausgang mit dem Gate des fünften Transfertransistors T5' verbunden ist.

In vergleichbarer Weise ist der Zusatz-Übertrag-Eingang RE über den gesteuerten Strompfad des siebten Transfertransistors T7 mit dem Schaltungsnullpunkt verbunden und über den des achten Transfertransistors T8 mit der konstanten Spannung U. Das Rückwärtszähl-Wahlsignal R ist dem Gate dieses Transfertransistors T8 und dem Eingang des fünften Inverters I5 zugeführt, dessen Ausgang mit dem Gate des siebten Transfertransistors T7 verbunden ist.

Schließlich ist der Zusatz-Übertrag-Ausgang RA' über den vom Vorwärtszähl-Ausgang VA gesteuerten Strompfad des neunten Transfertransistors T9 mit der konstanten Spannung U verbunden. Zur Auswahl der entsprechenden Zählrichtung muß das zugehörige Wahlsignal V, R den negativeren Pegel L zweier Binärsignalpegel annehmen, während das andere den H-Pegel aufweisen muß.

Mit der Weiterbildung nach Fig. 4 besteht also die Möglichkeit, mittels der nur die niederstwertige Stufe betreffenden Zusatzbeschaltung aus den Invertern I4, I5 und den Transfertransistoren T5', T6, T7, T8 und mittels der in jeder Stufe vorzusehenden zusätzlichen Transfertransistoren RT, T9 die Umschaltbarkeit von Vorwärts- auf Rückwärtszählen mit einfacheren Mitteln zu gewährleisten, als wenn die erwähnte Umschaltung der Vorwärts- oder Rückwärtszähl-Ausgänge VA, RA vorgenommen würde. Bei der Weiterbildung nach Fig. 4 kann auf einen der beiden Ausgänge VA, RA zur Abnahme von Signalen verzichtet werden, da sowohl bei Vorwärts- als auch bei Rückwärtszählen die entsprechenden Signale am Vorwärtszähl-Ausgang VA oder komplementär dazu am Rückwärtszähl-Ausgang RA abnehmbar sind.

Die Vorteile der zweiten Lösungsvariante nach der Fig. 2 und die der Weiterbildung nach Fig. 4 bestehen unter anderem darin, daß der H-Pegel der Taktsignale F1', F2' beliebig lang sein kann, so daß auch Signale mit niedriger Frequenz gezählt werden können, ferner ist auf die bei üblichen Synchronzählern erforderliche Synchronisation und Differenzierung des zu zählenden Signals auf die höhere Frequenz der Taktsignale des Zählers verzichtet. Auch hier liegen alle H-Pegel höchstens eine Gate-Schwellspannung niedriger als die konstante Spannung U.

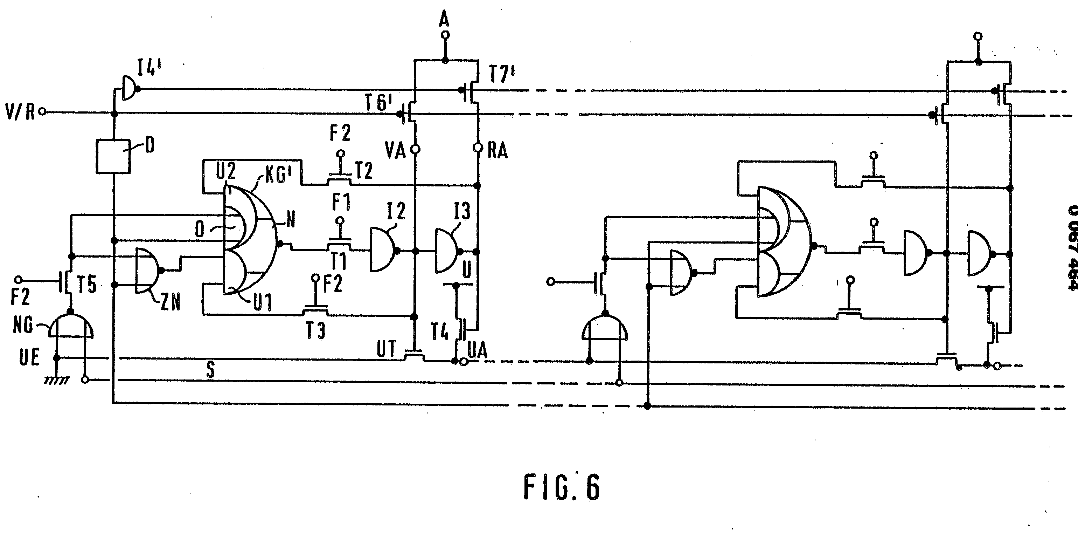

Die in Fig. 6 gezeigte Weiterbildung ermöglicht es, mit der ersten Lösungsvariante nach Fig. 1 einen Vorwärts/Rückwärtszähler aufzubauen. Hierzu ist in die zweite UND-Verknüpfung U2 die ODER-Verknüpfung O mit zwei Eingängen derart eingefügt, daß deren eine Eingangs-Ausgangs-Strecke (d. h. die Strecke, die einen der Eingänge der Verknüpfung mit deren Ausgang verbindet) zwischen dem fünften Transfertransistor T5 und dem diesem zugeordneten Eingang der zweiten UND-Verknüpfung U2 angeordnet ist. Ferner ist der erste Inverter I1 nach Fig. 1 durch die eine Eingangs-Ausgangs-Strecke des Zusatz-NOR-Gatters ZN ersetzt, dessen zweiter Eingang zusammen mit dem zweiten Eingang der ODER-Verknüpfung O am Ausgang des eingangsseitig mit dem Vorwärts/Rückwärts-Wahlsignal V/R gespeisten Differenzierglieds D liegt. Schließlich ist der Vorwärtszähl-Ausgang VA bzw. der Rückwärtszähl-Ausgang RA über die Schaltstrecke des sechsten bzw. des siebten Transfertransistors T6', T7' mit dem Ausgang A verbunden, wobei am Gate des sechsten Transfertransistors T6' das Vorwärts/Rückwärts-Wahlsignal V/R liegt und dem Gate des siebten Transfertransistors T7' über den vierten Inverter I4' dieses Wahlsignal zugeführt ist.

Das Differenzierglied D erzeugt aus dem Wahlsignal V/R bei jeder Impulsflanke, also bei jedem Wechsel von Vorwärtszählen auf Rückwärtszählen und umgekehrt, einen kurzen Impuls, wodurch der innerhalb des Synchronzählers vorhandene Zählerstand invertiert wird. Gleichzeitig erfolgt bezüglich des Ausgangs A eine Umschaltung vom bisher an ihm liegenden Ausgang entweder des zweiten oder des dritten Inverters I2, I3. Damit wird erreicht, daß, obwohl der innerhalb des Zählers ablaufende Zählvorgang nach wie vor in einer Richtung verläuft, bezüglich aller Ausgänge ein Binärsignal entsteht, das je nach gewählter Zählart in Vorwärtsrichtung oder in Rückwärtsrichtung sich verändert.

Diese Weiterbildung vergrößert somit die Einsatzmöglichkeiten des Synchronzählers.

Die geschilderten Vorwärts/Rückwärts-Zähler, insbesondere nach Fig. 4, können vorteilhaft in digitalen Integriergliedern eingesetzt werden, insbesondere wenn bei sehr hohen Frequenzen der Taktsignale F1, F2 in der Größenordnung von 10 MHz Zeitkonstanten in der Größenordnung μs realisiert werden sollen. Über eine geeignete Beschaltung des Stopeingangs jeder Stufe kann in einer derartigen Integratorschaltung die Integrationszeitkonstante variiert werden, z. B. schnell vorwärts und langsam rückwärts zählend.

Die Synchron-Binärzähler nach der Erfindung lassen sich sowohl mittels p-Kanal- als auch mit n-Kanal-Anreicherungstyp-Transistoren realisieren. Im letzteren Fall ist es besonders vorteilhaft, wenn die als Arbeitswiderstände dienenden Transistoren aus Verarmungstyp-Transistoren bestehen, also wenn sogenannte Depletion-Load-Elemente verwendet werden, da dann die auftretenden H-Pegel nur eine Transistorschwellspannung unter der konstanten Spannung U liegen.

Ferner ist es möglich, das der Erfindung zugrundeliegende Schaltungsprinzip auch in der Technik komplementärer Feldeffektransistor-Schaltungen, also in der sogenannten CMOS-Technik, zu realisieren. Dann sind die Transfertransistoren durch CMOS-Transmission-Gates zu ersetzen.

**Ansprüche**

1. Dynamischer Synchron-Binärzähler mit identischem Aufbau der Stufen, die mit Isolierschicht-Feldeffekttransistoren in mit zwei Taktsignalen (F1, F2, Figuren 1 und 2) betriebener Verhältnis-Schaltungstechnik realisiert sind und einen ersten, zweiten und dritten Inverter (I1, I2, I3), einen ersten, zweiten, dritten und vierten Transfertransistor (T1 ... T4) sowie einen Übertrag-Transfertransistor (UT) enthalten, wobei pro Stufe

— der zweite und dritte Inverter (I2, I3) direkt in Serie geschaltet sind und ihr Verbindungspunkt der Vorwärtszähl-Ausgang (VA) und der Ausgang des dritten Inverters (I3) der Rückwärtszähl-Ausgang (RA) ist,

— der Vorwärtszähl-Ausgang (VA) mit dem Gate des Übertrag-Transfertransistors (UT) verbunden ist,

— dem Eingang des zweiten Inverters (I2) der Strompfad des vom ersten Taktsignal (F1) gesteuerten ersten Transfertransistors (T1) vorgeschaltet ist,

— vom Rückwärtszähl-Ausgang (RA) der vom zweiten Taktsignal (F2) gesteuerte Transfertransistor (T2) in die Stufe zurückführt,

— der gesteuerte Strompfad des Übertrag-Transfertransistors (UT) zwischen Übertrag-Eingang (UE) und Übertrag-Ausgang (UA) der jeweiligen Stufe liegt und

— der Übertrag-Ausgang (UA) über den gesteuerten Strompfad des vierten Transfertransistors (T4) an konstanter Spannung (U) liegt, dessen Gate mit dem Rückwärtszähl-Ausgang (RA) verbunden ist,
gekennzeichnet durch folgende Merkmale :

— der dritte Transfertransistor (T3) ist vom zweiten Taktsignal (F2) gesteuert,

— der Übertrageingang (UE) der niederstwertigen Stufe liegt am Schaltungsnullpunkt,

— der erste Eingang eines NOR-Gatters (NG) liegt am Übertrag-Eingang (UE) und sein zweiter Eingang an einer für alle Stufen gemeinsamen Stoppleitung (S),

— der Ausgang eines Komplexgatters (KG) aus zwei NOR-verknüpften UND-Verknüpfungen (U1, U2) liegt über den ersten Transfertransistor (T1) am Eingang des zweiten Inverters (I2),

— der Vorwärtszähl-Ausgang (VA) liegt über den dritten Transfertransistor (T3) am ersten Eingang der ersten UND-Verknüpfung (U1), deren zweiter Eingang mit dem Ausgang des ersten Inverters (I1) verbunden ist,

— der Rückwärtszähl-Ausgang (RA) liegt über den zweiten Transfertransistor (T2) am ersten Eingang der zweiten UND-Verknüpfung (U2), deren zweiter Eingang zusammen mit dem Eingang des ersten Inverters (I1) über einen vom zweiten Taktsignal (F2) gesteuerten fünften Transfertransistor (T5) mit dem Ausgang des NOR-Gatters (NG) verbunden ist, und

— die Taktsignale (F1, F2) sind in an sich bekannter Weise nicht überlappende Zweiphasen-Taktsignale.

2. Dynamischer Synchron-Binärzähler mit identischem Aufbau der Stufen, die mit Isolierschicht-Feldeffekttransistoren in mit zwei Taktsignalen (F1', F2', Figur 3) betriebener Verhältnis-Schaltungstechnik realisiert sind und einen ersten, zweiten und dritten Inverter (I1', I2', I3'), einen ersten, zweiten, dritten und vierten Transfertransistor (T1' ... T4') sowie einen Übertrag-Transfertransistor (UT') enthalten, wobei pro Stufe

— der zweite und dritte Inverter (I2', I3') direkt in Serie geschaltet sind und ihr Verbindungspunkt der Vorwärtszähl-Ausgang (VA) und der Ausgang des dritten Inverters (I3') der Rückwärts-zähl-Ausgang (RA) ist,

— der Vorwärtszähl-Ausgang (VA) mit dem Gate des Übertrag-Transfertransistors (UT') verbunden ist,

— der Ausgang des ersten Inverters (I1') mit dem Eingang des zweiten Inverters (I2') über den vom ersten Taktsignal (F1') gesteuerten Strompfad des ersten Transfertransistors (T1') mit dem Ausgang des ersten Inverters (I1') verbunden ist, dessen Eingang über den Strompfad des zweiten Transfertransistors (T2') am Rückwärtszähl-Aus-gang (RA) liegt,

— der gesteuerte Strompfad des Übertrag-Transfertransistors (UT') zwischen Übertrageingang (UE) und Übertragausgang (UA) der jeweiligen Stufe liegt und

— der Übertragausgang (UA) über den gesteuerten Strompfad des vierten Transfertransistors (T4') an konstanter Spannung (U) liegt, dessen Gate mit dem Rückwärtszähl-Ausgang (RA) verbunden ist,
gekennzeichnet durch folgende Merkmale pro Stufe :

— der dritte Transfertransistor (T3') ist vom zweiten Taktsignal (F2') gesteuert,

— der Übertrageingang (UE) der niederstwertigen Stufe liegt beim Zählen am Schaltungsnullpunkt und beim Nichtzählen an konstanter Spannung (U),

— der erste Eingang eines NOR-Gatters (NG') liegt am Übertrageingang (UE), sein zweiter Eingang ist vom ersten Taktsignal (F1') gesteuert, und sein Ausgang ist mit dem Gate des zweiten Transfertransistors (T2') verbunden,

— der Vorwärtszähl-Ausgang (VA) liegt über den gesteuerten Strompfad des dritten Transfertransistors (T3') am Eingang des ersten Inverters (I1'), und

— das zweite Taktsignal (F2') ist aus dem ersten Taktsignal (F1') derart abgeleitet, daß die beiden H-L-Flanken synchron sind, die L-H-Flanke des zweiten Taktsignals (F2') gegenüber der des ersten (F1') jedoch mindestens um eine Zeit (t) verzögert ist, die gleich der Signallaufzeit des zweiten Inverters (I2') ist.

3. Synchron-Binärzähler nach Anspruch 2 als Vorwärts-Rückwärts-Zähler, gekennzeichnet durchfolgende Merkmale :

— in das NOR-Gatter (NG") ist durch Zuordnung zu dessen erstem Eingang eine UND-Verknüpfung (U1', Figur 4) eingefügt,

— für Rückwärtszählen ist ein Zusatz-Übertrag-Transfertransistor (RT) vorgesehen, dessen vom Rückwärtszähl-Ausgang (RA) gesteuerter Strompfad zwischen einem Zusatz-Übertrageingang (RE) und einem Zusatz-Übertragausgang (RA') liegt,

— der erste Eingang der UND-Verknüpfung (UI') liegt am Übertrageingang (UE) und dessen zweiter Eingang am Zusatz-Übertrageingang (RE),

— der Übertrageingang (UE) der niederstwertigen Stufe liegt über den gesteuerten Strompfad eines fünften Transfertransistors (T5') am Schaltungsnullpunkt und über den eines sechsten Transfertransistors (T6) an der konstanten Spannung (U), wobei das Gate des fünften Transfertransistors (T5') vom Ausgang eines vierten Inverters (I4) gesteuert ist, dessen Eingang zusammen mit dem Gate des sechsten Transfertransistors (T6) das Vorwärtszähl-Wahlsignal (V) zugeführt ist,

— der Zusatz-Übertrageingang (RE) der niederstwertigen Stufe liegt über den gesteuerten Strompfad eines siebten Transfertransistors (T7) am Schaltungsnullpunkt und über den eines achten Transfertransistors (T8) an der konstanten Spannung (U), wobei das Gate des siebten Transfertransistor (T7) vom Ausgang eines fünften Inverters (I5) gesteuert ist, dessen Eingang zusammen mit dem Gate des achten Transfertransistors (T8) das Rückwärtszähl-Wahlsignal (R) zugeführt ist, und

— der Zusatz-Übertragsausgang (RA') ist über den vom Vorwärtszähl-Ausgang (VA) gesteuerten Strompfad eines neunten Transfertransistors (T9) mit der konstanten Spannung (U) verbunden.

4. Synchron-Binärzähler nach Anspruch 1, gekennzeichnet durch folgende Merkmale :

— in die zweite UND-Verknüpfung (U2) ist eine ODER-Verknüpfung (O, Figur 6) mit zwei Eingängen derart eingefügt, daß deren eine Eingangs-Ausgangs-Strecke zwischen dem fünften Transfertransistor (T5) und dem diesem zugeordneten Eingang der zweiten UND-Verknüpfung (U2) liegt,

— der erste Inverter (I1) ist durch die eine Eingangs-Ausgangs-Strecke eines Zusatz-NOR-Gatters (ZN) ersetzt, dessen zweiter Eingang zusammen mit dem zweiten Eingang der ODER-Verknüpfung (O) am Ausgang eines eingangsseitig mit dem Vorwärts/Rückwärts-Wahlsignal (V/R) gespeisten Differenziergliedes (D) liegt, und

— der Vorwärtszähl-Ausgang (VA) bzw. der Rückwärtszähl-Ausgang (RA) bildet über die Schaltstrecke eines sechsten Transfertransistors (T6'), dessen Gate das Vorwärts/Rückwärts-Wahlsignal (V/R) zugeführt ist, bzw. über die Schaltstrecke eines siebten Transfertransistors (T7'), dessen Gate über einen vierten Inverter (I4') dieses Wahlsignal (V/R) zugeführt ist, den Ausgang (A) der jeweiligen Stufe.

5. Synchron-Binärzähler nach einem der Ansprüche 1 bis 4 dadurch gekennzeichnet, daß sämtliche Transistoren n-Kanal-Anreicherungstyp-Transistoren und die Arbeitswiderstände von Invertern und Gattern n-Kanal-Verarmungstyptransistoren (Depletion-Load-Elemente) sind.

6. Verwendung von Binärzählern nach Anspruch 1 oder 5 zur Realisierung digitaler Integrierglieder.

**Claims**

1. Dynamic synchronous binary counter with ratio-type stages of identical design which are implemented with insulated-gate field-effect transistors, are operated with two clock signals (F1, F2, figs. 1, 2) and contain first, second, and third inverters (I1, I2, I3), first, second, third and fourth transfer transistors (T1 to T4), and one carry transfer transistor (UT), wherein in each stage

— the second and third inverters (I2, I3) are connected directly in series, their node being the count-up output (VA), and the output of the third inverter (I3) being the count-down output (RA) ;

— the count-up output (VA) is coupled to the gate of the carry transfer transistor (UT) ;

— the input of the second inverter (I2) is preceded by the current path of the first transfer transistor (T1), which is controlled by the first clock signal (F1) ;

— the second transfer transistor (T2), which is controlled by the second clock signal (F2), is connected from the count-down output (RA) back to the stage ;

— the controlled current path of the carry transfer transistor (UT) is connected between a carry input (UE) and a carry output (UA) of the stage,

— the carry output (UA) is connected to a constant voltage (U) through the controlled current path of the fourth transfer transistor (T4), whose gate is connected to the count-down output (RA) ;

characterized by the following features :

— the third transfer transistor (T3) is controlled by the second clock signal (F2)

— the carry input (UE) of the least significant stage is connected to ground ;

— the first input of a NOR gate (NG) is connected to the carry input (UE), and its second input is connected to a stop line (S) being common to all stages,

— the output of a complex gate (KG) consisting of two NORed AND elements (U1, U2) is coupled to the input of the second inverter (I2) through the first transfer transistor (T1) ;

— the count-up output (VA) is coupled through the third transfer transistor (T3) to the first input of the first AND element (U1), whose second input is connected to the output of the first inverter (I1) ;

— the count-down output (RA) is coupled through the second transfer transistor (T2) to the first input of the second AND element (U2), whose second input, together with the input of the third inverter (I1), is connected to the input of the NOR gate (NG) through a fifth transfer transistor (T5), which is controlled by the second clock signal (F2), and

— the clock signals (F1, F2) are nonoverlapping two-phase clock signals as are used in the prior art.

2. Dynamic synchronous binary counter with ratio-type stages of identical design which are implemented with insulated-gate field-effect transistors, are operated with two clock signals (F1', F2', fig. 3) and contain first, second, and third inverters (I1', I2', I3'), first, second, third and fourth transfer transistors (T1' to T4'), and one carry transfer transistor (UT'), wherein in each stage

— the second and third inverters (I2', I3') are connected directly in series, their node being the count-up output (VA), and the output of the third inverter (I3') being the count-down output (RA) ;

— the count-up output (VA) is coupled to the gate of the carry transfer transistor (UT') ;

— the input of the second inverter (I2') is preceded by the current path of the first transfer transistor (T1'), which is controlled by the first clock signal (F1') ;

— the second transfer transistor (T2'), which is controlled by the second clock signal (F2'), is connected from the count-down output (RA) back to the stage ;

— the controlled current path of the carry transfer transistor (UT') is connected between a carry input (UE) and a carry output (UA) of the stage,

— the carry output (UA) is connected to a constant voltage (U) through the controlled current path of the fourth transfer transistor (T4'), whose gate is connected to the count-down output (RA) ;

characterized by the following features in each stage :

— the third transfer transistor (T3) is controlled by the second clock signal (F2)

— the carry input (UE) of the least significant stage is grounded during counting, and connected to a constant voltage (U) when no counting takes place ;

— the first input of a NOR gate (NG') is connected to the carry input (UE), its second input is controlled by the first clock signal (F1'), and its output is coupled to the gate of the second transfer transistor (T2') ;

— the count-up output (VA) is coupled to the input of the first inverter (I1') through the controlled current path of the third transfer transistor (T3') ; and

— the second clock signal (F2') is derived from the first clock signal (F1') in such a way that the two trailing edges are synchronous, while the leading edge of the second clock signal (F2') is delayed with respect to that of the first (F1') by a period (T) at least equal to the propagation delay of the second inverter (I2').

3. A synchronous binary counter as claimed in claim 2 and used as an up-down counter, characterized by the following features :

— The NOR gate (NG") contains an AND elements (U1', fig. 4) associated with its first input ;

— for backward counting, and additional carry transfer transistor (RT) is provided whose current path controlled by the count-down output (RA) is inserted between an additional carry input (RE) and an additional carry output (RA') ;

— the first input of the AND element (U1') is connected to the carry input (UE), and its second input is connected to the additional carry input (RE) ;

— the carry input (UE) of the least significant stage is grounded through the controlled current path of a fifth transfer transistor (T5') and connected to the constant voltage (U) through the controlled current path of a sixth transfer transistor (T6), the gate of the fifth transfer transistor (T5') being controlled by the output of a fourth inverter (I4), whose input, together with the gate of the sixth transfer transistor (T6), is fed with the « up » control signal (V) ;

— the additional carry input (RE) of the least significant stage is grounded through the controlled current path of a seventh transfer transistor (T7) and connected to the constant voltage (U) through the controlled current path of an eighth transfer transistor (T8), the gate of the seventh transfer transistor (T7) being controlled by the output of a fifth inverter (I5), whose input, together with the gate of the eighth transfer transistor (T8), is fed with the « down » control signal (R), and

— the additional carry output (RA') is connected to the constant voltage (U) through the current path of a ninth transfer transistor (T9), which is controlled by the count-up output (VA).

4. A synchronous binary counter as claimed in claim 1, characterized by the following features :

— An OR element (O) with two inputs is so incorporated in the second AND element (U2) that one of its input-output paths is inserted between the fifth transfer transistor (T5) and that input of the second AND element (U2) which is associated with the fifth transfer transistor (T5) ;

— the first inverter (I1) is replaced with one of the input-output paths of an additional NOR gate (ZN) whose second input, together with the second input of the OR element (O), is connected to the output of a differentiator (D) fed with the up/down control signal (V/R), and

— the count-up output (VA) is connected to the output (A) via the controlled current path of a sixth transfer transistor (T6'), whose gate is fed with the up/down control signal (V/R), and the count-down output (RA) is connected to the output (A) via the controlled current path of a seventh transfer transistor (T7'), whose gate is fed with this control signal (V/R) through a fourth inverter (I4').

5. A synchronous binary counter as claimed in any one of claims 1 to 4 characterized in that all transistors are n-channel enhancement-mode transistors, and that the load resistors of inverters and gates are n-channel depletion-mode transistors.

6. Use of binary counters as claimed in claim 1 or 5 for the implementation of digital integrators.

**Revendications**

1. Compteur binaire synchrone dynamique à étages de structure identique du type à circuits proportionnels à deux signaux d'horloge (F1 et F2, figures 1 et 2), réalisés à l'aide de transistors à effet de champ à grille isolée et comportant un premier, un deuxième et un troisième inverseur (I1, I2, I3), un premier, un deuxième, un troisième et un quatrième transistors de transfert (T1 ... T4) ainsi qu'un transistor de transfert de report (UT), tandis que, par étage :
— le deuxième et le troisième inverseurs (I2, I3) sont montés directement en série et leur point de raccordement constitue la sortie de comptage en avant (VA) et la sortie du troisième inverseur (I3) constitue la sortie du comptage en arrière (VA),
— la sortie de comptage en avant (VA) est reliée à la grille du transistor de transfert de report (UT),
— le trajet de courant du premier transistor de transfert (T1) commandé par le premier signal d'horloge (F1) est monté en série avec l'entrée du deuxième inverseur,
— le transistor de transfert (T2) commandé par le deuxième signal d'horloge (F2) ramène de la sortie de comptage en arrière (RA) à l'étage,
— le trajet de courant commandé du transistor de transfert de report (UT) se situe entre l'entrée de report (UE) et la sortie de report (UA) de l'étage correspondant,
— la sortie de report (UA) est connectée à la tension constante (U), par l'intermédiaire du trajet de courant commandé du quatrième transistor de transfert (T4) dont la grille est reliée à la sortie de comptage en arrière (RA),
caractérisé en ce que :
— le troisième transistor (T3) est commandé par le deuxième signal d'horloge (F2),
— l'entrée de report (UE) de l'étage de plus faible poids se trouve au potentiel de référence du circuit,
— la première entrée d'une porte NOR (NG) est connectée à l'entrée de report (UE) et sa deuxième entrée à une ligne d'arrêt (S) commune à tous les étages,
— la sortie d'une porte complexe (KG) comprenant deux éléments ET (U1, U2) combinés par un élément NOR est connectée, par l'intermédiaire du premier transistor de transfert (T1), à l'entrée du deuxième inverseur (I2),
— la sortie de comptage en avant (VA) est connectée, par l'intermédiaire du troisième transistor de transfert (T3), à la première entrée du premier élément ET (U1), dont la deuxième entrée est reliée à la sortie du premier inverseur (I1),
— la sortie de comptage en arrière (RA) est connectée, par l'intermédiaire du premier transistor de transfert (T2), à la première entrée du deuxième élément ET (U2) dont la deuxième entrée est reliée, en même temps que l'entrée du premier inverseur (I1), à la sortie de la porte NOR (NG), par l'intermédiaire d'un cinquième transistor de transfert (T5) commandé par le deuxième signal d'horloge et
— les signaux d'horloge (F1, F2) sont des signaux d'horloge à deux phases ne se chevauchant pas, d'une façon en elle-même connue.

2. Compteur binaire synchrone dynamique à étages de structure identique du type à circuits proportionnels à deux signaux d'horloge (F1', F2', figure 3), réalisé à l'aide de transistors à effet de champs à grille isolée et comportant un premier, un deuxième et un troisième inverseur (I1', I2', I3'), un premier, un deuxième, un troisième et un quatrième transistors de transfert (T1' ... T4') ainsi qu'un transistor de transfert de report, tandis que par étage :
— le deuxième et le troisième inverseurs (I2', I3') sont montés directement en série et leur point de raccordement constitue la sortie de comptage en avant (VA) et la sortie du troisième inverseur (I3') constitue la sortie de comptage en arrière (RA),
— la sortie de comptage en avant (VA) est reliée à la grille du transistor de transfert de report (UT'),
— la sortie du premier inverseur (I1') est reliée à l'entrée du deuxième inverseur (I2'), par l'intermédiaire du trajet de courant du premier transistor de transfert (T1') qui est commandé par le premier signal d'horloge (F1'), l'entrée du premier inverseur (I1') étant connectée à la sortie de comptage en arrière (RA), par l'intermédiaire du trajet de courant du deuxième transistor de transfert (T2'),
— le trajet de courant commandé du transistor de transfert de report (UT') est connecté entre l'entrée de report (UE) et la sortie de report (UA) de l'étage considéré,
— la sortie de report (UA) étant connectée à la tension constante (U) par l'intermédiaire du trajet de courant commandé du quatrième transistor de transfert (T4') dont la grille est reliée à la sortie de comptage en arrière (RA),
caractérisé en ce que :
— le troisième transistor de transfert (T3') est commandé par le deuxième signal d'horloge (F2'),
— l'entrée de transfert (UE) de l'étage de plus faible poids est connectée, pour le comptage, au potentiel de référence du circuit et, pour le non-comptage, à une tension constante (U),
— la première entrée d'une porte NOR (NG') est connectée à l'entrée de report (UE), sa deuxième entrée étant commandée par le premier signal d'horloge (F1') et sa sortie connectée à la grille du deuxième transistor de transfert (T2'),

— la sortie de comptage en avant (VA) est connectée, par l'intermédiaire du trajet de courant commandé du troisième transistor de transfert (T3'), à l'entrée du premier inverseur (I1'), et

— le deuxième signal d'horloge (F2') est dérivé du premier signal de synchronisation (F1') de telle sorte que les deux flancs arrière (H-L) sont synchrones, le flanc avant (L-H) du deuxième signal (F2') étant par ailleurs retardé par rapport à celui du premier signal (F1') d'un temps (t) au moins égal au temps de propagation des signaux du deuxième inverseur.

3. Compteur binaire synchrone selon la revendication 2, fonctionnant en compteur-décompteur, caractérisé en ce que :

— il est inséré dans la porte NOR (NG''), affecté à sa première entrée, un élément ET (U1'), (figure 4),

— il est prévu pour le comptage en arrière un transistor de transfert de report (RT) supplémentaire dont le trajet de courant commandé par la sortie de comptage en arrière (RA) se trouve entre une entrée de report (RE) supplémentaire et une sortie de report (RA') supplémentaire,

— la première entrée de l'élément ET (U1') est connectée à l'entrée de report (UE) et sa deuxième entrée à l'entrée de report (RE) supplémentaire,

— l'entrée de report (UE) de l'étage de plus faible poids est connectée, par l'intermédiaire du trajet de courant commandé d'un cinquième transistor de transfert (MT5') au potentiel de référence du circuit et est connectée, par l'intermédiaire d'un sixième transistor de transfert (T6) à la tension constante (U), cependant que la grille du cinquième transistor de transfert (T5') est commandée par la sortie d'un quatrième inverseur (I4) à l'entrée duquel est amené, en même temps qu'à la grille du sixième transistor de transfert (T6), le signal de sélection du comptage en avant (V),

— l'entrée de report (RE) supplémentaire de l'étage de plus faible poids est connectée, par l'intermédiaire du trajet de courant commandé d'un septième transistor de transfert (T7), au potentiel de référence du circuit et est connectée, par l'intermédiaire du trajet de courant d'un huitième transistor de transfert (T8), à la tension constante (U), cependant que la grille du septième transistor de transfert (T7) est commandée par la sortie d'un cinquième inverseur (I5), à l'entrée duquel est amené, en même temps qu'à la grille du huitième transistor de transfert (T8), le signal de sélection du comptage en arrière (R) et

— la sortie de report (RA') supplémentaire est reliée à la tension constante (U) par l'intermédiaire du trajet de courant d'un neuvième transistor de transfert (T9) qui est commandé par la sortie de comptage en avant.

4. Compteur binaire synchrone selon la revendication 1, caractérisé en ce que :

— il est inséré dans le deuxième élément ET (U2) un élément OU (O, figure 6) à deux entrées tel qu'un parcours d'entrée-sortie de celui-ci se trouve entre le cinquième transistor de transfert (T5) et l'entrée du deuxième élément ET (U2) qui est affectée à celui-ci,

— le premier inverseur (I1) est remplacé par un des parcours d'entrée-sortie d'une porte NOR (ZN) supplémentaire, dont la deuxième entrée se trouve, en même temps que la deuxième entrée de l'élément OU (O), à la sortie d'un élément de différenciation alimenté côté entrée par le signal de sélection en avant/en arrière (V/R) et

— la sortie de comptage en avant (VA) ou la sortie de comptage en arrière (RA) constitue la sortie (A) de l'étage considéré, par l'intermédiaire du parcours de couplage d'un sixième transistor de transfert (T6') à la grille duquel est amené le signal de sélection en avant/en arrière (V/R) ou, par l'intermédiaire du parcours de couplage d'un septième transistor de transfert (T7'), à la grille duquel est amené ce signal de sélection (V/R) au moyen d'un quatrième inverseur (I4').

5. Compteur binaire synchrone selon une des revendications 1 à 4, caractérisé en ce que tous les transistors sont des transistors du type à enrichissement à canal N et en ce que les résistances de charge des inverseurs et des portes sont des transistors du type à appauvrissement à canal N.

6. Utilisation de compteurs binaires selon l'une des revendications 1 à 5 pour la réalisation de dispositifs d'intégration numériques.

0 067 464

FIG. 1

FIG. 2

FIG. 3

1

FIG. 4

FIG. 5

FIG.6